# EUROPEAN PATENT APPLICATION

(11) **EP 4 671 799 A1**
(43) Date of publication of application: **31.12.2025**
(21) Application number: 24886419.1
(22) Date of filing: 29.10.2024
(51) Int. Cl.: G01R 31/52, G01R 31/392, G01R 31/382, G01R 19/12, G01R 19/165, H02J 7/00, H01M 50/105

(54) **METHOD FOR INSPECTING SHORT CIRCUIT IN SECONDARY BATTERY CELL**

(30) Priority: 30.10.2023 KR 20230146407
(71) Applicant: LG Energy Solution, Ltd., Seoul 07335 (KR)
(72) Inventor: PARK, Wook, Daejeon 34122 (KR); LIM, Dae Bong, Daejeon 34122 (KR); KIM, Yun Sic, Daejeon 34122 (KR); KIM, A Young, Daejeon 34122 (KR); HAN, Dong Il, Daejeon 34122 (KR); LEE, Gi Seok, Daejeon 34122 (KR); LEE, Mi Sun, Daejeon 34122 (KR); DONG, Han Sae, Daejeon 34122 (KR); KIM, Yeon Woo, Daejeon 34122 (KR)
(74) Representative: Goddar, Heinz J.
(86) International application number: PCT/KR2024/096414
(87) International publication number: WO 2025/095749

(57) **Abstract**

Disclosed herein is a method for short circuit inspection of a secondary battery cell which includes preparing a fully-packaged secondary battery cell, micro-charging the secondary battery cell to a state of charge (SOC) in a range of 0.03% to 0.05%, measuring an open-circuit voltage drop caused by a self-discharge of the micro-charged secondary battery cell, and determining the secondary battery cell as a defective product if a change rate per hour of the measured open-circuit voltage drop exceeds a predetermined reference value.

## Description

### [Technical Field]

The present disclosure relates to an inspection method that can detect with high accuracy the presence of a short circuit of a positive electrode and/or a negative electrode due to a defect in a separator at an early stage, prior to the activation process for a fully-packaged secondary battery cell.

This application claims the benefit of priority from Korean Patent Application No. 10-2023-0146407, filed on October 30, 2023, and all of the contents of the Korean Patent Application are incorporated by reference into this disclosure.

### [Background]

Secondary batteries, unlike primary batteries, are rechargeable and have been widely researched and developed in recent years due to the potential for miniaturization and large capacity. In addition, as the technological development and demand for mobile devices increases, the demand for secondary batteries as an energy source is increasing rapidly due to the increasing emphasis on electric vehicles and energy storage systems, etc. in response to the current environmental protection needs.

Secondary batteries are categorized into coin-type batteries, cylindrical batteries, prismatic batteries, and pouch-type batteries based on the shape of the battery case. In secondary batteries, an electrode assembly mounted on the inside of the battery case is a power generation element capable of charging and discharging comprising a stacked structure of electrodes and separators.

The electrode assembly can be roughly classified into a Jellyroll type in which a separator is interposed and wound between sheet-type positive and negative electrodes coated with active materials; a Stack type in which a plurality of positive and negative electrodes are sequentially stacked with separators interposed; and a Stack & Folding type in which unit cells of the stack type are wound with a long length of separation film.

The secondary battery is completely sealed after inserting the electrode assembly into the battery case and injecting the electrolyte. The assembled secondary battery undergoes an activation process that repeats charging and discharging for a certain period of time, and after various inspections including charging and discharging performance, electrolyte leakage, and external appearance defects during or after the activation process, it is shipped as a product.

The activation process is a process that brings the function of the secondary battery to a shippable level by repeating charging and discharging over a long period of several days. However, if defects such as tearing or folding of the separator occur in the secondary battery cell during the various manufacturing processes, a short circuit may occur in the positive electrode and/or negative electrode, and secondary batteries that cause low voltage defects due to such separator problems cannot be shipped as good products. As such, if low voltage defects are detected only after completing packaging and going through the activation process, there is a significant loss in time and cost in secondary battery manufacturing, so it is necessary to filter out low voltage defect cells as early as possible, especially before the time-consuming activation process.

### [Summary]

### [Technical Problem]

The object of the present disclosure is to provide a method capable of detecting low voltage defects due to separator problems with high accuracy at an early stage immediately after packaging, prior to insertion into a time-consuming activation process.

However, the technical problem to be solved by the present disclosure is not limited to the above-described problem, and other problems not mentioned can be clearly understood by a person skilled in the art from the description of the disclosure described below.

### [Technical Solution]

The present disclosure relates to a method for short circuit inspection of a secondary battery cell, which includes, in one example, preparing a fully-packaged secondary battery cell, micro-charging the secondary battery cell to a state of charge (SOC) in a range of 0.03% to 0.05%, measuring an open-circuit voltage drop caused by a self-discharge of the micro-charged secondary battery cell, and determining the secondary battery cell as a defective product if a change rate per hour of the measured open-circuit voltage drop exceeds a predetermined reference value.

In one embodiment of the present disclosure, the secondary battery cell may be micro-charged for 2 minutes to 5 minutes at a current amount of 1/200C to 1/50C (wherein 1C is a current amount that fully charges the secondary battery cell in 1 hour).

Here, the micro-charging of the secondary battery cell may be performed at less than a reaction potential that activates the secondary battery cell.

Further, the open-circuit voltage drop due to self-discharge can be measured while the secondary battery cell is heated to 50°C to 70°C.

In one embodiment, the secondary battery cell is a pouch cell, and the open-circuit voltage drop due to self-discharge can be measured while heating the pouch cell to 50°C to 70°C, and also applying pressure.

For example, the pouch cell may be pressurized to a pressure of 5 kgf/cm² to 14 kgf/cm².

Alternatively, the pouch cell may be pressurized in a pressure range of 14 kgf/cm² or more and less than the damage pressure of the pouch cell.

Further, the pressure may be applied across the entire surface of the pouch cell.

In one embodiment of the present disclosure, the secondary battery cell is a pouch cell, and the open-circuit voltage drop due to self-discharge can be measured by subjecting the pouch cell to a state of charge (SOC) of 0.05%, a current amount of 1/50C (wherein 1C is a current amount to fully charge the secondary battery cell in 1 hour), heating to 50°C to 60°C, and applying pressure to the entire surface of the pouch cell at a pressure of 14 kgf/cm² for 5 minutes.

Further, the predetermined reference value for the change rate per hour of the open-circuit voltage drop may be set at a 4 sigma level for the change rate per hour of the open-circuit voltage drop of a good quality secondary battery cell.

### [Advantageous Effects]

According to the short circuit inspection method for secondary battery cells of the present disclosure, which performs a series of steps as described above, by micro-charging the secondary battery cell before performing the activation process and measuring the open-circuit voltage drop due to self-discharge for a short period of time, low voltage defects caused by short circuits between positive/negative electrodes due to tearing or folding of the separator can be detected with high reliability.

Accordingly, defective products can be effectively screened out prior to the time-consuming activation process, thereby preventing time and cost losses in secondary battery manufacturing.

However, the technical effects that can be obtained through the present disclosure are not limited to the above-described effects, and other effects not mentioned can be clearly understood by a person skilled in the art from the description of the disclosure described below.

### [Brief Description of the Drawings]

Because the following drawings attached to the present specification illustrate exemplary embodiments of the present disclosure and serve to facilitate understanding of the technical idea of the present disclosure together with the detailed description of the disclosure described below, the present disclosure should not be limitedly interpreted on the basis of the drawings.
FIG. 1 is a diagram schematically illustrating a device for performing a short circuit inspection method of a secondary battery cell according to the present disclosure.
FIG. 2 is a flowchart for a short circuit inspection method of a secondary battery cell according to the present disclosure.
FIG. 3 is a graph illustrating a drop rate per hour of an open-circuit voltage compared to a charging amount of a secondary battery cell.
FIG. 4 is a graph illustrating an open-circuit voltage drop comparing good quality and defective secondary battery cells.
FIG. 5 is a graph illustrating a gap difference with good quality products according to changes in SOC and charging current amount.
FIG. 6 is a graph illustrating a gap difference between defective product and good quality product according to pressure increase.
FIG. 7 is a graph illustrating changes in short circuit detection capability according to pressure increase.

### [Best Mode]

The present disclosure may have various modifications and various embodiments, and thus specific embodiments thereof will be described in detail below.

However, it should be understood that the present disclosure is not limited to the specific embodiments, and includes all modifications, equivalents, or alternatives within the spirit and technical scope of the present disclosure.

The terms "comprise," "include," and "have" used herein designate the presence of characteristics, numbers, steps, actions, components, or members described in the specification or a combination thereof, and it should be understood that the possibility of the presence or addition of one or more other characteristics, numbers, steps, actions, components, members, or a combination thereof is not excluded in advance.

In addition, in the present disclosure, when a part of a layer, film, region, plate, or the like is disposed "on" another part, this includes not only a case in which one part is disposed "directly on" another part, but a case in which still another part is interposed therebetween. In contrast, when a part of a layer, film, region, plate, or the like is disposed "under" another part, this includes not only a case in which one part is disposed "directly under" another part, but a case in which still another part is interposed therebetween. In addition, in the present application, "on" may include not only a case of being disposed on an upper portion but also a case of being disposed on a lower portion.

The present disclosure relates to a method for short circuit inspection of a secondary battery cell. In one example, the method includes: preparing a fully-packaged secondary battery cell, micro-charging the secondary battery cell to a state of charge (SOC) in a range of 0.03% to 0.05%, measuring an open-circuit voltage drop caused by a self-discharge of the micro-charged secondary battery cell, and determining the secondary battery cell as a defective product if a change rate per hour of the measured open-circuit voltage drop exceeds a predetermined reference value.

According to the short circuit inspection method for secondary battery cells of the present disclosure, which performs a series of steps as described above, by micro-charging the secondary battery cell prior to performing the activation process and measuring the open-circuit voltage drop due to self-discharge for a short period of time, low voltage defects caused by short circuits between positive/negative electrodes due to tearing or folding of the separator can be detected with high reliability.

Accordingly, defective products can be effectively screened out prior to the time-consuming activation process, thereby preventing time and cost losses in secondary battery manufacturing.

### [Detailed Description]

Hereinafter, specific embodiments of a short circuit inspection method for a secondary battery cell according to the present disclosure (hereinafter, may be simply referred to as a "short circuit inspection method") will be described in detail with reference to the accompanying drawings. For reference, the directions of front, back, up, down, left, and right used in the following description to designate relative positions are for the purpose of understanding the disclosure and refer to the directions shown in the drawings unless otherwise specified.

### [first embodiment]

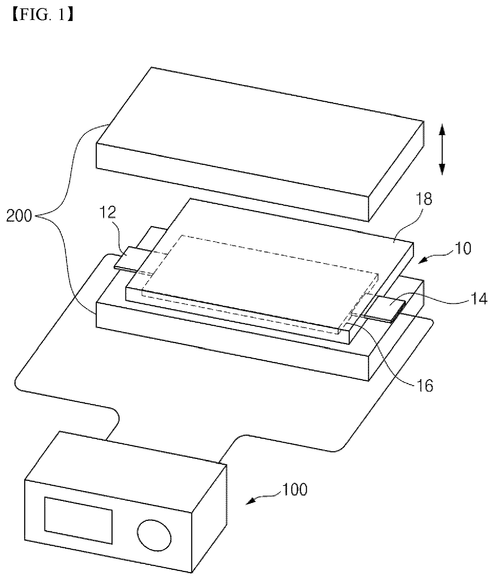

FIG. 1 is a diagram schematically illustrating a device for performing a short circuit inspection method of a secondary battery cell according to the present disclosure. The secondary battery cell illustrated in FIG. 1 is a pouch cell 10, wherein the pouch cell 10 accommodates an electrode assembly and electrolyte in the interior, and has electrode leads of a positive electrode 12 and a negative electrode 14 drawn out to the outside of a pouch of packaging material. Charging and discharging is performed through the electrode leads of the positive electrode 12 and negative electrode 14 exposed to the outside. For sealing, the borders of the pouch are bonded by thermal fusion. For example, the bottom of the pouch cell 10 is a folding region where the pouch is folded in half, and a thermally bonded border is not formed, and three other borders may form a thermally fused border. Among these three thermally fused borders, the border from which the electrode leads 12, 14 are drawn out is referred to the terrace portion 16, and the remaining thermally fused border forms the gas pocket portion 18. After the activation process, the gas generated in the interior of the pouch is discharged through a hole perforated in the gas pocket portion 18.

Then, in FIG. 1, a micro-charge voltage tracking (MVT) device 100 for performing a short circuit inspection method is illustrated. The MVT device 100 performs a micro-charge on the secondary battery cell 10, and measures an open-circuit voltage drop due to self-discharge of the secondary battery cell 10 after charging. During micro-charging, the MVT device can perform constant current charging by limiting the maximum charging current, thereby charging at a constant current based on the load characteristics of the secondary battery cell.

In addition, the device of FIG. 1 includes a pressing device 200 that applies pressure to the secondary battery cell 10. While the pressing device 200 may selectively be used when performing the short circuit inspection method of the present disclosure, it is preferred that the pressing device 200 be used to improve the accuracy of detecting defective cells. In particular, since the pressing device 200 is directed to apply pressure to the surface of the secondary battery cell 10 to pressurize the electrode assembly of the interior, it may be preferable to necessarily use the pressing device 200 in the case of targeting pouch cell 10 applied with flexible packaging material.

When applying the pressing device 200 to the pouch cell 10, it may be preferable for the pressing device 200 to apply pressure across the entire surface of the pouch cell 10. By applying pressure to the entire surface of the pouch cell 10, rather than only the border, it becomes possible to detect separator folding that occurs at the edges of the electrode assembly, as well as separator tearing that occurs at the edges and center of the electrode assembly. In addition, by pressurizing the pouch cell 10, it becomes possible to detect small-sized separator defects that were not detected when pressure was not applied or when only the borders were pressurized.

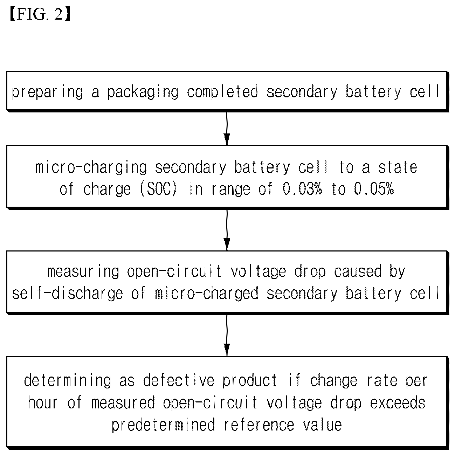

FIG. 2 is a flowchart of a short circuit inspection method of the present disclosure. Referring to FIG. 2, the short circuit inspection method of the present disclosure includes the steps of preparing a fully-packaged secondary battery cell, micro-charging the secondary battery cell, measuring an open-circuit voltage drop of the secondary battery cell, and determining a good quality and defective secondary battery cells based on a change rate per hour of the measured open-circuit voltage drop.

A fully-packaged secondary battery cell refers to a secondary battery cell accommodated with an electrode assembly and electrolyte in a packaging material, as shown in FIG. 1, and sealed so that the electrodes (or electrode leads) of the positive electrode and the negative electrode are exposed to the outside. In other words, the short circuit inspection method begins by preparing an externally finished secondary battery cell immediately prior to insertion into the activation process.

The fully-packaged secondary battery cell is micro-charged through the MVT device. If the level of micro-charging is defined quantitatively, it corresponds to a state of charge (SOC) of the secondary battery cell in a range of 0.03% to 0.05%. Here, the micro-charging of the secondary battery cell is performed by a constant current charging method.

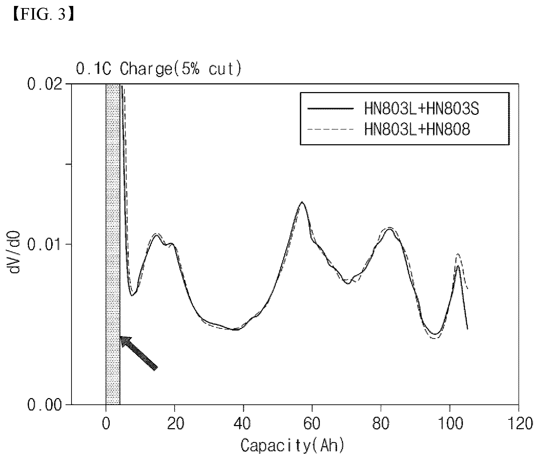

When micro-charging is completed, through the MVT device, the open-circuit voltage drop due to self-discharge of the secondary battery cell is measured. FIG. 3 is a graph illustrating a drop rate per hour of an open-circuit voltage compared to a charging amount of a secondary battery cell. Referring to FIG. 3, the drop rate per hour of open-circuit voltage drop shows an irregular pattern according to the charging amount of the secondary battery cell, especially in the region where the SOC is very low, for example, in the region of 0.03% to 0.05%, which is the micro-charging range of the present disclosure, the drop rate per hour of open-circuit voltage drop shows a sharp slope. In other words, in the section of SOC 0.03% to 0.05%, the open-circuit voltage drops rapidly in a short time, and thus measuring the drop rate per hour of the open-circuit voltage in this section can sensitively determine the good quality or defective of the secondary battery cell.

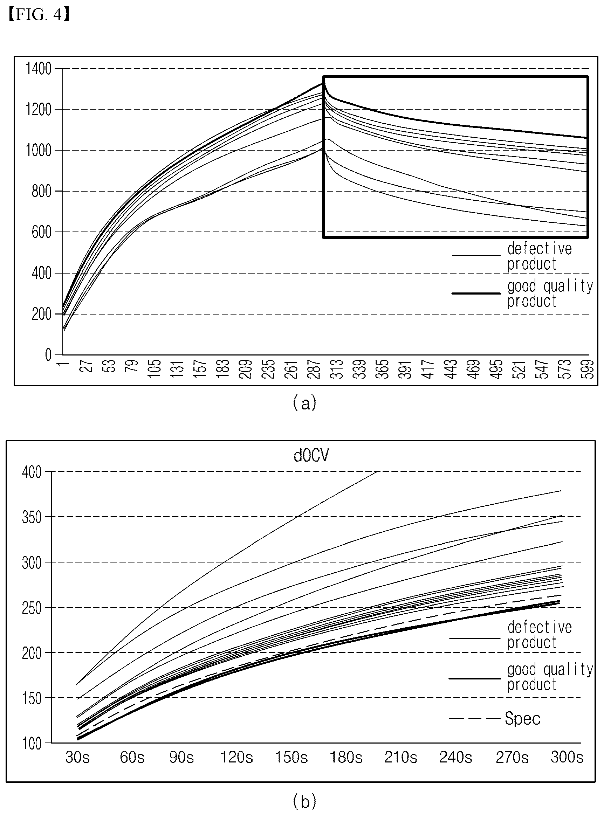

Based on such facts, when the change rate per hour of the measured open-circuit voltage drop exceeds a predetermined reference value, it is determined to be a defective product. FIG. 4 is a graph illustrating an open-circuit voltage drop comparing good quality and defective secondary battery cells. The defective product is a defective secondary battery cell with artificially made separator defects. On the left is a graph illustrating the voltage under micro-charge and self-discharge, and on the right is a graph illustrating the drop rate per hour of the open-circuit voltage under self-discharge. As shown in the graph on the right, a good quality secondary battery cell has a good voltage drop rate that is below the pass specification (red line), but a defective secondary battery cell has a high voltage drop rate that exceeds the pass specification. Therefore, when the change rate per hour of the measured open-circuit voltage drop exceeds a predetermined reference value, the secondary battery cell can be determined to be a defective product.

### (Experimental Example 1) Gap difference with good quality products according to the charging amount of micro-charging and charging current amount

Table 1 below summarizes the six experimental conditions for three levels of SOC(%) and two levels of charging current amount. In the six experimental conditions, the pressure applied to the pouch cell was the same as 5 kgf/cm².

**[Table 1]**

| Experiment Number | SOC(%) | Charging current amount (C) | Pressure (kgf/cm²) | Micro-charging time (min) |
|---|---|---|---|---|
| 1 | 0.033 | 1/200 | 5 | 4 |
| 2 | 0.033 | 1/50 | 5 | 1 |
| 3 | 0.042 | 1/200 | 5 | 5 |
| 4 | 0.042 | 1/50 | 5 | 2 |
| 5 | 0.050 | 1/200 | 5 | 6 |
| 6 | 0.050 | 1/50 | 5 | 2 |

The experiment was conducted with 67 defective pouch cells that were artificially created with separator folding or tearing in either the edge or central area of the electrode assembly. As shown in Table 1, the basic unit of charging current amount "1C" refers to the current amount that fully charges the secondary battery cell in 1 hour, and the experiment was conducted by varying two variables of SOC(%) and charging current amount(C) while maintaining a fixed pressure condition of 5kgf/cm². Additionally, the open-circuit voltage drop due to self-discharge was measured while heating the secondary battery cell to an appropriate temperature in the range of 50°C to 70°C, for example, 55°C.

Here, the reason for limiting the state of charge (SOC) of the secondary battery cell to the range of 0.03% to 0.05% is because, as explained with reference to FIG. 3, this corresponds to the micro-charging range in which the drop rate per hour of open-circuit voltage shows the steepest slope. In addition, corresponding to the SOC range of 0.03% to 0.05%, the charging current amount was limited to 1/50C or less because the micro-charging of the secondary battery cell should proceed below the reaction potential that activates the secondary battery. For example, if the activation potential (reaction potential) of the secondary battery cell is approximately 2V or more, it is needed to maintain the charging potential during micro-charging at approximately 1.5V.

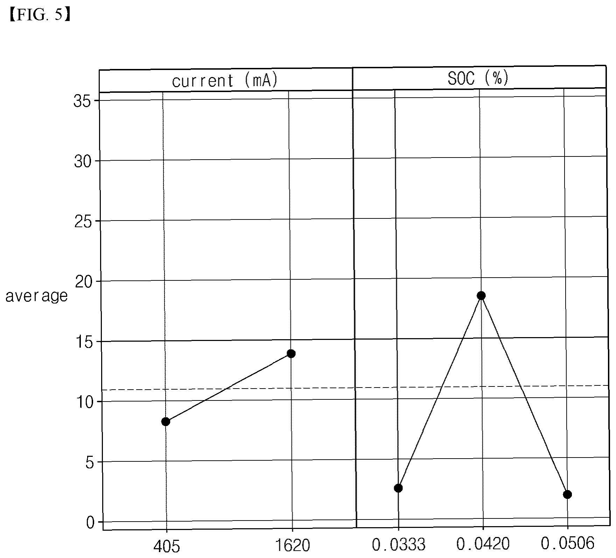

FIG. 5 is a graph illustrating a gap difference with good quality products according to changes in SOC and charging current amount. The more clearly the open-circuit voltage drop of the defective product appears compared to the good product, in other words, the larger the gap in open-circuit voltage drop of the defective product compared to the good product, the higher the discriminating power to filter out defective products. From such perspective, when viewing FIG. 5, the gap in open-circuit voltage drop of the defective product compared to the good quality product appeared larger as the charging current amount of the secondary battery cell increased. However, when the SOC increased from 0.033% to 0.042%, the gap increased, but when further increased to 0.050%, the gap tended to return to the 0.033% level. Based on these results, under the premise that it proceeds below the reaction potential that activates the secondary battery, setting the charging current amount as high as possible for micro-charging of the secondary battery cell appears advantageous for short-circuit inspection of secondary battery cells.

### (Experimental Example 2) Gap difference with good quality products according to pressure of micro-charging

Table 2 below summarizes the experimental conditions conducted with the pressure applied across the entire surface of the pouch cell as the main factor.

**[Table 2]**

| Experiment Number | SOC(%) | Charging current amount (C) | Pressure (kgf/cm²) | Micro-charging time (min) |
|---|---|---|---|---|
| 7 | 0.042 | 1/200 | 8 | 5 |
| 8 | 0.042 | 1/50 | 8 | 2 |
| 9 | 0.050 | 1/50 | 8 | 2 |
| 10 | 0.050 | 1/50 | 11 | 2 |
| 11 | 0.050 | 1/50 | 14 | 2 |

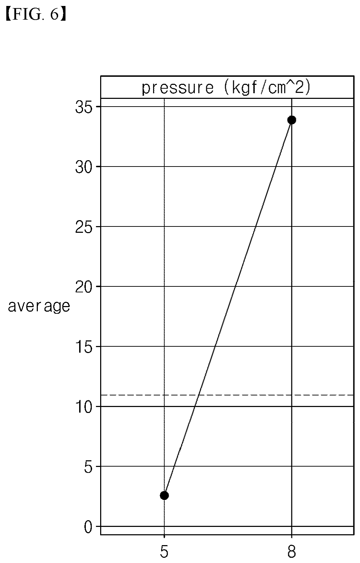

FIG. 6 is a graph illustrating a gap difference between defective product and good quality product according to pressure increase. As shown in FIG. 6, compared to FIG. 5, the effect of increasing gap difference according to pressure increase appeared the largest.

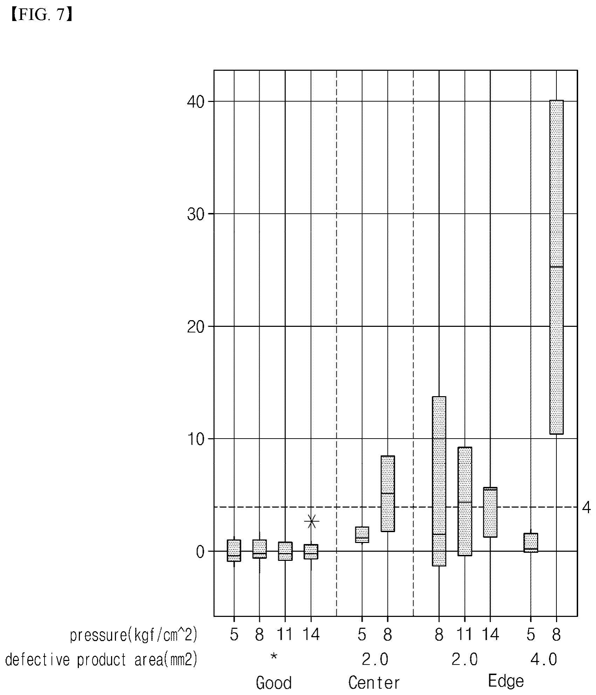

FIG. 7 is a graph illustrating changes in short circuit detection capability according to pressure increase. The pressure was limited to an upper limit of 14kgf/cm² level, which is the maximum that the current equipment can apply. Then, the defective size of the separator was prepared with a 2.0(mm²) size at the center of the electrode assembly, and two sizes of 2.0/4.0(mm²) at the edge of the electrode assembly.

As shown in FIG. 7, as expected, only open-circuit voltage drops below the standard appeared in good quality products, and the width of the open-circuit voltage drop increased with the increase in pressure in both the central area and the edge of the electrode assembly. It was possible to detect separator defects that were previously undetectable by increasing the pressure, and such detection capability was found to increase almost proportionally to the increase in pressure. Therefore, if the pressurization equipment is complemented, it is expected that the ability to detect separator defects can be further improved by pressurizing the pouch cell to 14kgf/cm² or more within a pressure range below the damage pressure of the pouch cell.

Moreover, based on the experimental results, it is understood that the increase of the charging current amount and pressure has a positive effect on the detection of short circuits, while the state of charge (SOC) does not have a significant effect on the detection result when it is in a range of 0.03% to 0.05% in which the drop rate per hour of the open-circuit voltage is the maximum. In this respect, it may be desirable to set the charging current amount and state of charge so that the micro-charging can be completed in a short period of time, such as 2 minutes to 5 minutes.

### [second embodiment]

When establishing the three factors, that is, charging amount, charging current amount, and pressure which were treated as main factors for detecting separator defects in the first embodiment, as preferable process conditions for the short circuit inspection method of pouch cells, that is, conditions that can be applied to current production facilities without significant issues, they are as follows.

The secondary battery cell is directed to a pouch cell in which externally applied pressure acts directly on the internal electrode assembly, and the process conditions can be established to measure the open-circuit voltage drop due to self-discharge for 5 minutes while the pouch cell is at a state of charge (SOC) of 0.05%, using a current amount of 1/50C (wherein 1C is a current amount that fully charges the secondary battery cell in 1 hour), heated to 50°C to 60°C, and applying pressure to the entire surface of the pouch cell at a pressure of 14 kgf/cm².

Further, the predetermined reference value for the change rate per hour of the open-circuit voltage drop may be set at a 4 sigma level for the change rate per hour of the open-circuit voltage drop of a good quality secondary battery cell. Since managing at a 3 sigma level would present a producer risk for secondary battery cell defects, preferably, the change rate per hour of the open-circuit voltage drop can be applied at a 4 sigma level. The voltage drop rate at the 4 sigma level is indicated by a dashed line in FIG. 7.

As aforementioned, the present disclosure has been described in more detail through the drawings, embodiments, and the like. However, since the configuration described in the drawings or embodiments, etc. described herein is merely one embodiment of the present disclosure and does not represent the overall technical spirit of the disclosure, it should be understood that the disclosure covers various equivalents, modifications, and substitutions at the time of filing of this application.

### [Description of Reference Numerals]

10: secondary battery cell (pouch cell)
12: positive electrode
14: negative electrode
16: terrace portion
18: gas pocket portion
100: MVT device
200: pressing device

## Claims

1. A method for short circuit inspection of a secondary battery cell, comprising:
preparing a fully-packaged secondary battery cell;
micro-charging the secondary battery cell to a state of charge SOC in a range of 0.03% to 0.05%;
measuring an open-circuit voltage drop caused by a self-discharge of the micro-charged secondary battery cell; and
determining the secondary battery cell as a defective product if a change rate per hour of the measured open-circuit voltage drop exceeds a predetermined reference value.

2. The method for short circuit inspection of a secondary battery cell of claim 1, wherein the secondary battery cell is micro-charged for 2 minutes to 5 minutes at a current amount of 1/200C to 1/50C, wherein 1C is a current amount that fully charges the secondary battery cell in 1 hour.

3. The method for short circuit inspection of a secondary battery cell of claim 2, wherein the micro-charging of the secondary battery cell is performed at less than a reaction potential that activates the secondary battery cell.

4. The method for short circuit inspection of a secondary battery cell of claim 2, wherein the open-circuit voltage drop due to self-discharge is measured while the secondary battery cell is heated to 50°C to 70°C.

5. The method for short circuit inspection of a secondary battery cell of claim 4, wherein the secondary battery cell is a pouch cell, and
the open-circuit voltage drop due to self-discharge is measured while heating the pouch cell to 50°C to 70°C, and also applying pressure.

6. The method for short circuit inspection of a secondary battery cell of claim 5, wherein the pouch cell is pressurized to a pressure of 5 kgf/cm² to 14 kgf/cm².

7. The method for short circuit inspection of a secondary battery cell of claim 5, wherein the pouch cell is pressurized in a pressure range of 14 kgf/cm² or more and less than the damage pressure of the pouch cell.

8. The method for short circuit inspection of a secondary battery cell of any one of claims 5 to 7, wherein the pressure is applied across the entire surface of the pouch cell.

9. The method for short circuit inspection of a secondary battery cell of claim 1, wherein the secondary battery cell is a pouch cell, and
the open-circuit voltage drop due to self-discharge is measured by subjecting the pouch cell to a state of charge SOC of 0.05%, a current amount of 1/50C, heating to 50°C to 60°C, and applying pressure to the entire surface of the pouch cell at a pressure of 14 kgf/cm² for 5 minutes, wherein 1C is a current amount to fully charge the secondary battery cell in 1 hour.

10. The method for short circuit inspection of a secondary battery cell of claim 1, wherein the predetermined reference value for the change rate per hour of the open-circuit voltage drop is set at a 4 sigma level for the change rate per hour of the open-circuit voltage drop of a good quality secondary battery cell.
